Europäisches Patentamt

European Patent Office

Office européen des brevets

(11) Veröffentlichungsnummer: **0 242 542**

**A1**

(12) **EUROPÄISCHE PATENTANMELDUNG**

(21) Anmeldenummer: **87102919.5**

(22) Anmeldetag: **02.03.87**

(51) Int. Cl.4: **G01R 1/067** , G01R 1/073 , **H01R 11/18**

(30) Priorität: **26.03.86 DE 3610153**

(43) Veröffentlichungstag der Anmeldung:
**28.10.87 Patentblatt 87/44**

(84) Benannte Vertragsstaaten:
**AT BE CH DE FR GB IT LI NL**

(71) Anmelder: **Feinmetall Gesellschaft mit beschränkter Haftung**
**Zeppelinstrasse 2**
**D-7033 Herrenberg(DE)**

(72) Erfinder: **Krüger, Gustav, Dr.**
**Danziger Strasse 1**
**D-7033 Herrenberg(DE)**

(74) Vertreter: **König, Oskar, Dr.-Ing. Dipl.-Phys.**
**Klüpfelstrasse 6 Postfach 51**
**D-7000 Stuttgart 1(DE)**

(54) **Prüfadapter.**

(57) Prüfadapter (110) zum Kontaktieren von Leiterplatten (116) zwecks deren Prüfung. Er weist eine Vielzahl von metallischen Federkontaktstiften (111) auf. Der Federkontaktstift (111) weist einen Zylinder (129') auf, in dem ein Kolben (124) eines Kolbengliedes (119) axial gleitbar gelagert ist, das über den Zylindermantel (117) des Zylinders (129') übersteht und eine Bohrung (130) einer rückwärtigen Führungsplatine (131) des Prüfadapters (110) durchdringt. Auf dem über den Zylinder (129') überstehenden Bereich des Kolbengliedes (119) ist eine Schraubendruckfeder (120) angeordnet. Das Kolbenglied (119) ist kürzer als die halbe Gesamtlänge des unbelasteten Federkontaktstiftes (111) und die Schraubendruckfeder (120) befindet sich zumindest teilweise innerhalb der Bohrung (130) der rückwärtigen Führungsplatine (131).

FIG.2

EP 0 242 542 A1

Die Erfindung betrifft einen Prüfadapter zum Kontaktieren von Leiterplatten gemäß dem Oberbegriff des Anspruches 1.

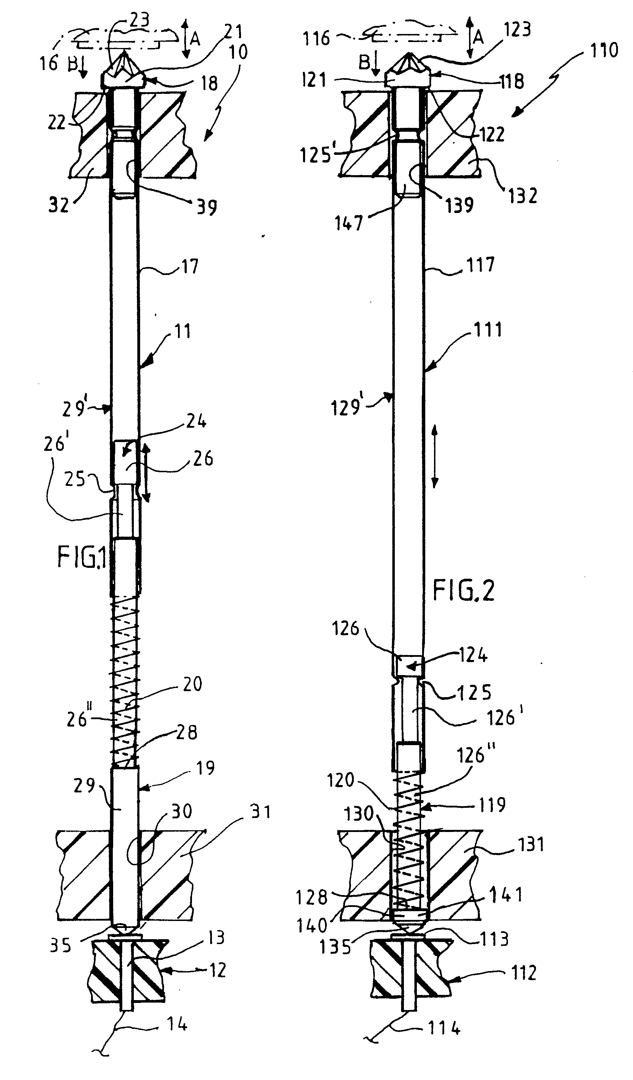

In Fig. 1 ist ein vorbekannter Prüfadapter 10 dieser Art ausschnittsweise dargestellt. Er weist eine Vielzahl von zueinander parallel angeordneten, unter sich gleich ausgebildeten, geraden Federkontaktstiften 11 auf. Bspw. kann er mehrere oder oft sogar viele tausend solcher Federkontaktstifte aufweisen, von denen ein Federkontaktstift dargestellt ist. Der Prüfadapter weist einen plattenförmigen, starren, unbeweglichen Anschlußkontaktträger 12 auf, an dem gegeneinander elektrisch isolierte metallische Anschlußkontakte angeordnet sind, von denen einer zu sehen und mit 13 bezeichnet ist. An jeden Anschlußkontakt ist ein weiterführender elektrischer Leiter 14 angeschlossen, der zu einem nicht dargestellten Auswertegerät oder Auswerter führt, das die elektrische Prüfung der Leiterplatten unter Mitwirkung dieses Prüfadapters 10 durchführt. Um eine ausschnittsweise strichpunktiert angedeutete Leiterplatte 16 durch die Federkontaktstifte, wie 11, dieses Prüfadapters 10 zu kontaktieren, ist vertikale Relativbewegung in Richtung des Doppelpfeiles A zwischen der Leiterplatte 16 und dem Prüfadapter 10 möglich.

Dieser vorbekannte Federkontaktstift 11 weist im unbelasteten Zustand eine Gesamtlänge von ca.65mm auf.Er besteht aus einem dünnen, rohrförmigen Zylindermantel 17, einem massiven Kontaktglied 18, einem Kolbenglied 19 und einer Schraubendruckfeder 20. Der Außendurchmesser des Zylindermantels 17 beträgt ca. 1,18 mm. Das Kontaktglied 18 ist fest in den vorderen Endbereich des Zylindermantels 17 eingesetzt und steht über diesen Zylindermantel 17 mit seinem untenseitig eine Ringschulter 22 bildenden Kontaktkopf 21 um 2 mm über, dessen Spitze 23 zum Inkontaktkommen mit der betreffenden Leiterplatte 16 bestimmt ist. Vom unteren Ende her ist in diesen rotationssymmetrischen, im wesentlichen kreiszylindrischen Zylindermantel 17 das rotationssymmetrische Kolbenglied 19 koaxial eingesetzt. Dieses massive Kolbenglied 19 weist einen im Zylindermantel 17 axial gleitbar gelagerten Kolben 24 auf, der im unbelasteten Zustand des Federkontaktstiftes mit einer durch eine Einschnürung 26' gebildeten Ringschulter infolge der Vorspannung der Feder 20 an einer ringförmigen Einwölbung 25 des Zylindermantels anliegt, die sich fast genau in halber Höhe des unbelasteten Federkontaktstiftes 11 befindet. Die Länge des aus vernickeltem und gehärtetem Stahl bestehenden Kolbengliedes 19 beträgt 36 mm und ist damit 1,1-fach länger als die Hälfte der Gesamtlänge des unbelasteten Federkontaktstiftes 11. Der Zylindermantel 17 und das in ihm unbeweglich gehaltene Kontaktglied 18 bilden zusammen einen obenseitig

geschlossenen Zylinder 29', in dem der Kolben 24 mit seinen beiden Bereichen 26, 26" gleiten kann, von denen der Bereich 26" ständig aus dem Zylinder 29' herausragt. Dieser Kolben 24 weist die seine axiale Beweglichkeit ergebende Einschnürung 26' auf. Auf dem Bereich 26" des Kolbens 24 ist außerhalb des Zylindermantels 17 die Schraubendruckfeder 20 angeordnet, die sich einerseits am rückwärtigen Stirnende des Zylindermantels 17 und andererseits am Kolbenglied 19 an einem Ringbund 28 abstützt, an dem ein 14,5 mm langer zylindrischer Führungsabschnitt 29 vergößerten Durchmessers des Kolbengliedes 19 beginnt, der bis zur 0,5 mm langen Spitze 35 des Kolbengliedes 19 reicht, die auf dem zugeordneten Anschlußkontakt 13 des Trägers 12 aufliegt. Im unbelasteten Zustand des Federkontaktstiftes 11 ist die Feder 20 im dargestellten, vorgespannten Zustand 8 mm lang. Die Länge des Zylindermantels 17 beträgt 40 mm.

Der zylindrische Führungsabschnitt 29 ist gleitbar in einer zylindrischen Bohrung 30 einer rückwärtigen Führungsplatine 31 des Prüfadapters 10 mit geringem Gleitlagerspiel axial geführt. Der Zylindermantel 17 ist in einer Bohrung 39 der vorderen Führungsplatine 32 des Prüfadapters 10 mit geringem Gleitlagerspiel axial geführt. Diese vordere Führungsplatine 32 ist in Richtung des Doppelpfeiles A , d. h. in Richtung der Längsachse des Federkontaktstiftes 11 axial beweglich und durch nicht dargestellte Rückstellfedermittel belastet. Zur Prüfung einer Leiterplatte 16 wird diese auf die Kontaktspitzen 23 der Federkontaktstifte 11 in vorbestimmter Stellung gedrückt und dann in Richtung des Pfeiles B eine vorbestimmte Strecke bewegt, wodurch die Kontaktglieder 18 mit den mit ihnen fest verbundenen Zylin dermänteln 17 in Richtung des Pfeiles B bewegt werden. Hierdurch wird durch Anlage der rückwärtigen Ringschultern 22 der Kontaktköpfe 21 an der vorderen Führungsplatine 32 auch diese Führungsplatine 32 mit diesen Kontaktgliedern 18 und den Zylindermänteln 17 in Richtung des Pfeiles B mitbewegt und die Schraubendruckfedern 20 werden dabei um einen vorbestimmten Federweg von bspw. 4 mm stärker zusammengedrückt, so daß sie die Kontaktspitzen 23 mit vorbestimmten Kräften an die Leiterplatte 16 andrücken und das Auswertegerät kann nunmehr die elektrische Prüfung der Leiterplatte 16 auf Fehlerfreiheit durchführen. Anschließend wird die Leiterplatte 16 vom Prüfadapter 10 wieder abgenommen und die Kontaktglieder 18 mit den Zylindermänteln 17, sowie auch die vordere Führungsplatine 32 kehren dann in ihre Ruhestellungen durch die Wirkung der Rückstellfedern zurück. Die Feder 20 befindet sich ständig außerhalb der Führungsplatine 31, so daß der Führungsabschnitt 29 ihre Bohrung 30 ständig auf

voller Länge durchdringt. Es liegt großer Überstand des Kolbengliedes 19 über den Zylindermantel von 23 mm in unbelastetem Zustand des Federkontaktstiftes 11 vor und es muß deshalb auch der im Zylindermantel 17 befindliche Bereich des Kolbens 24 zur guten Führung relativ lang sein, nämlich 13 mm. Insgesamt hat das Kolbenglied 19 bei diesem Federkontaktstift relativ große Länge von 36 mm, was seine Herstellung beträchtlich verteuert, so daß der Kostenaufwand des Kolbengliedes an den Gesamtkosten des Federkontaktstiftes relativ groß ist.

Es ist deshalb eine Aufgabe der Erfindung, einen Prüfadapter gemäß dem Oberbegriff des Anspruches 1 zu schaffen, dessen Federkontaktstifte bei gegebener Gesamtlänge kostengünstiger hergestellt werden können.

Diese Aufgabe wird erfindungsgemäß durch einen Prüfadapter gemäß Anspruch 1 gelöst.

Durch die Erfindung gelingt bei unveränderter Gesamtlänge des unbelasteten Federkontaktstiftes von bspw. zweckmäßig ca. 65 mm erhebliche Verkürzung des Kolbengliedes und damit erhebliche Senkung seiner Herstellungskosten, indem sich die Schraubendruckfeder nicht mehr vollständig zwischen der rückwärtigen Führungs platine des Prüfadapters und dem Zylindermantel des jeweiligen Federkontaktstiftes, sondern sich zumindest teilweise innerhalb der betreffenden Bohrung der rückwärtigen Führungsplatine befindet. Hierdurch erniedrigen sich die Herstellungskosten des Federkontaktstiftes. Auch kann der kostengünstig herstellbare Zylindermantel, welcher bspw. aus Bronze oder sonstigen leicht zu bearbeitenden Metallen bestehen kann, länger und hierdurch der Überstand des Kolbengliedes über diesen Zylindermantel kleiner gemacht werden, was zusätzlich zur Folge hat, daß das Kolbenglied zu seiner ausreichenden axialen Führung in den Zylindermantel weniger tief eindringen muß als bei dem vorbekannten Federkontaktstift gemäß Fig. 1.

Auch läßt sich infolge der auf das Kolbenglied einwirkenden geringeren Kippmomente der Verschleiß verringern und die Standzeit des Federkontaktstiftes erhöhen. Auch läßt sich das Gewicht der Federkontaktstifte verringern und damit die Belastung des Prüfadapters durch sie, was weitere Vorteile nach sich zieht.

Auch können die Abmessungen des erfindungsgemäßen Federkontaktstiftes so sein, daß er an die Stelle der vorbekannten Federkontaktstifte 11 gemäß Fig. 1 treten kann, so daß die Dimensionierungen der Teile 12, 13, 31 und 32 des in Fig. 1 dargestellten Prüfadapters 10 unverändert bleiben können.

Durch die Erfindung gelingt es ohne weiteres, zu erreichen, daß das Kolbenglied bei unveränderter Gesamtlänge des unbelasteten Federkontaktstiftes sogar viel kürzer als die halbe Gesamtlänge des unbelasteten Federkontaktstiftes sein kann. Vorzugsweise kann vorgesehen sein, daß das Verhältnis der Länge des unbelasteten Federkontaktstiftes zur Länge des Kolbengliedes größer als 2:1, vorzugsweise größer als 2,5 : 1 ist. Besonders günstig ist es, wenn dieses Verhältnis 3:1 bis 4:1 beträgt. Hierdurch lassen sich die Herstellungskosten und der Verschleiß des Kolbengliedes und des Federkontaktstiftes besonders stark verringern und die Führung des Kolbengliedes im Zylinder wird erleichtert und verbessert.

In Fig. 2 ist ein Prüfadapter 110 gemäß einem Ausführungsbeispiel der Erfindung in ausschnittsweiser , geschnittener Darstellung dargestellt, wobei diese Fig. 2 nur einen einzigen Federkonkaktstift 111 zeigt.

Der Federkontaktstift besteht aus einem Zylinder 129', einem in diesem axial gleitbar gelagerten Kolbenglied 119 und einer zylindrischen Schraubendruckfeder 120. Der Zylinder 129' besteht aus einem rohrförmigen Zylindermantel 117, in den ein Kontaktglied 118, das dem Kontaktglied 18 der Fig. 1 entsprechen kann, fest eingesetzt ist und den dem Inkontaktkommen mit Leiter platten, wie 116, dienenden Kontaktkopf 121 mit Kontaktspitze 123 aufweist.

Der Prüfadapter 110 weist außer dem dargestellten Federkontaktstift 111 noch eine größere bis sehr große Anzahl, vorzugsweise Tausende oder viele Tausende gleicher Federkontaktstifte 111 auf, wobei alle diese Federkontaktstifte 111 mit den rückwärtigen Spitzen 135 ihrer Kolbenglieder 119 auf zugeordneten Anschlußkontakten 113 des Trägers 112 aufliegen. Dieser Träger 112 mit Anschlußkontakten 113 kann unverändert dem Träger 12 mit Anschlußkontakten 13 nach Fig. 1 entsprechen. Auch die vordere Führungsplatine 132 und ihre bewegliche Lagerung (Doppelpfeil A) und Federung kann unverändert der Führungsplatine 32 nach Fig. 1 und ihrer Lagerung und Federung entsprechen desgl. die Durchmesser der Bohrungen 139 für die Federkontaktstifte 111. Die rückwärtige Führungsplatine 131 kann in ihrer Gestalt und den Durchmessern ihrer Bohrungen 130 der Führungsplatine 31 der Fig. 1 entsprechen. Sie ist bei diesem Prüfadapter 110 in geringem Abstand von vorzugsweise ca. 0,5 bis 1,5 mm von den Anschlußkontakten 113 am Prüfadapter 110 fest angeordnet.

Der gerade Federkontaktstift 111 kann im unbelasteten Zustand dieselbe Gesamtlänge von ca. 65 mm aufweisen wie der Federkontaktstift 11 nach Fig. 1.Desgleichen kann der Außendurchmesser seines Zylindermantels 117 ebenfalls ca. 1,18 mm betragen. Es sind jedoch auch andere Abmessungen dieses Federkontaktstiftes 111, falls erwünscht, möglich. Der vordere Endbereich seines Zylindermantels 117 ist in der Bohrung 139 der vorderen Führungsplatine 132 mit geringem Gleitlagerspiel axial geführt.

Bei diesem Federkontaktstift 111 nach Fig. 2 ist der rotationssymmetrische Zylindermantel 117 mit Ausnahme von zwei ringförmigen Sicken 125 und 125′ kreiszylindrisch. Dieser Zylindermantel 117 ist im Verhältnis zur Gesamtlänge des Federkontaktstiftes 111 länger als der Zylindermantel 17 des Federkontaktstiftes 11 nach Fig. 1, bspw. zweckmäßig ca. 51 mm lang, da die zylindrische Schraubendruckfeder 120, welche im dargestellten, vorgespannten Zustand eine Länge von vorzugsweise mindestens 7 mm, bevorzugt von ca. 10 mm haben kann, in unbelastetem Zustand des Federkontaktstiftes 111, wie dargestellt, auf einem erheblichen Teil ihrer Länge in die Bohrung 130 hineinragt und diese nahezu durchdringt. Der hierdurch erreichte geringere Überstand des Kolbengliedes 119 über den Zylindermantel 117 verringert bereits die Länge des Kolbengliedes 119 beträchtlich und ermöglicht zusätzlich, daß das Kolbenglied 119 in den Zylindermantel 117 weniger tief einzudringen braucht, als bei dem Federkontaktstift 11 nach Fig. 1. Dieser Überstand des Kolbengliedes 119 über den Zylindermantel 117 bei unbelastetem Federkontaktstift 111 kann vorzugsweise ungefähr 9 bis 13 mm, besonders zweckmäßig ungefähr 11 mm betragen. Die Gesamtlänge des unbelasteten Federkontaktstiftes 111 beträgt hier ca. das 3,5-fache der Länge des Kolbengliedes 119, so daß die Herstellung dieses Kolbengliedes 119 wesentlich kostengünstiger ist als die des Kolbengliedes 19 der Fig. 1. Die Länge des Kolbengliedes 119 kann bspw. zweckmäßig ca. 18 mm bei einer Gesamtlänge des unbelasteten Federkontaktstiftes von ca. 65 mm Länge betragen.

Das massive Kolbenglied 119, das zweckmäßig einstückig hergestellt sein kann, vorzugsweise aus gehärtetem und vernickeltem Stahl bestehen kann, besteht aus dem Kolben 124, dessen gleich große Durchmesser aufweisenden Bereiche 126, 126″ im Zylindermantel 117 mit geringem Gleitlagerspiel axial geführt sind und einem kurzen, an den Kolben 124 anschließenden Endabschnitt 140. Der vorzugsweise nur 0,8 bis 5 mm, hier ca. 1 mm lange Endabschnitt 140 weist einen kurzen, bspw. ca. 0,5 mm langen zylindrischen Bereich 141 auf, an den die kegelförmige Spitze 135 anschließt, die auf dem Anschlußkontakt 113 aufliegt. Dieser zylindrische Bereich 140 ragt zum Teil in die Bohrung 130 mit geringem Gleitlagerspiel hinein, so daß der Federkontaktstift 111 sowohl in der vorderen als auch in der rückwärtigen Führungsplatine 132 bzw. 131 mit geringem axialen Gleitlagerspiel geführt ist.

Der Bereich 140 des Kolbengliedes 119 taucht jedoch in die Bohrung 130 nur geringfügig ein ,vorzugsweise nur ungefähr 0,3 bis 1,5 mm. Dieser Bereich 140 geht mit einem Ringbund 128, auf dem die Feder 120 unter Vorspannung anliegt, in den Bereich 126″ des Kolbens 124 über. Die außerhalb des Zylinders 129′ befindliche Feder 120 stützt sich obenseitig am unteren Stirnende des Zylindermantels 117 ab. Dieser Zylindermantel 117 bildet mit dem Kontaktglied 118 den obenseitig abgeschlossenen Zylinder 129′, in dem der Kolben 124 axial gleitbar geführt ist.

Der Kolben 124 weist eine seine axiale Beweglichkeit im Zusammenwirken mit der Sicke 125 bewirkende, ständig innerhalb des Zylinders 129′ befindliche Einschnürung 126′ auf, die den Kolben 124 in den zweckmäßig nur ca. 1 bis 2 mm langen Endbereich 126 und den längeren Bereich 126″ trennt.

Der Außendurchmesser der Feder 120 ist, wenn sie vollständig zusammengedrückt ist, geringfügig kleiner als der Durchmesser der Bohrung 130 der rückwärtigen Führungsplatine 131. Die Schraubendruckfeder 120 ist ständig vorgespannt. Ihre Länge kann in der unbelasteten Stellung des Federkontaktstiftes vorzugsweise ungefähr 7 bis 10 mm betragen. Die Sicke 125′ des Zylindermantels 117 hält das Kontaktglied 118 und die Sicke 125 bildet einen Anschlag für den Kolbenbereich 126 im unbelasteten Zustand des Federkontaktstiftes 111.

Das massive Kontaktglied 118 des Federkontaktstiftes 111 nach Fig. 2 kann entsprechend dem Kontaktglied 18 des Federkontaktstiftes 11 nach Fig. 1 ausgebildet und im Zylindermantel 117 angeordnet und gehalten sein. Die Kontaktspitze 123 kann irgendeine gewünschte Ausbildung aufweisen, bspw. die dargestellte mit mehreren scharfen, sich am vorderen Ende dieser Spitze treffenden Kanten.

Der Federkontaktstift 111 nach Fig. 2 ist wegen der erheblich kostengünstigeren Bauart des Kolbengliedes 119 erheblich kostengünstiger als der Federkontaktstift 11 nach Fig. 1. Da solche Prüfadapter 110 im allgemeinen sehr große Anzahlen solcher Federkontaktstifte aufweisen, im allgemeinen mehrere tausend oder viele tausend solcher Federkontaktstifte 111, bspw. ca. 20 000 Federkontaktstifte 111, sind die Ersparnisse entsprechend groß. Auch wird das Gewicht des Federkontaktstiftes 111 und damit das Gewicht des Prüfadapters 110 vorteilhaft durch das kürzere Kolbenglied 119 verringert.

Das Kolbenglied 119 wie auch das Kontaktglied 118 können einstückige Teile sein. Das Kontaktglied 118 kann ebenfalls wie das Kolbenglied 119 aus gehärtetem, vernickeltem Stahl bestehen. Der Zylindermantel 117 kann aus Bronze oder einem sonstigen geeigneten elektrisch gut leitendem Metall bestehen.

Das Kolbenglied 119,der Zylindermantel 117 und der im Zylindermantel 117 befindliche Schaft 147 des Kontaktgliedes 118 sind jeweils rotationssymmetrisch und zueinander koaxial. Auch der Kontaktkopf 121 weist einen rotationssymmetrischen Abschnitt auf, an den die die Spitze 123 bildenden schrägen Flächen anschließen. Diese Kontaktspitze 123 dient dem Inkontaktkommen mit Leiterplatten 116. Der Kontaktkopf 121 bildet rückseitig einen Ringbund 122, der über den Zylindermantel 117 auf ihm aufsitzend allseitig übersteht und der Mitnahme der vorderen Platine 132 bei dem Kontaktieren von Leiterplatten 116 in Richtung des Pfeiles B dient. Dieser Ringbund 122 kann ständig an der Platine 132 anliegen oder bei unbelastetem Federkontaktstift 111 sich, wie dargestellt, in geringem Abstand oberhalb der Platine 132 befinden.

Bei der Prüfung einer Leiterplatte 116 wird diese auf den Prüfadapter 110 in Richtung des Pfeiles B zubewegt und/oder der Prüfadapter in Gegenrichtung auf die Leiterplatte 116 zubewegt und die Leiterplatte 116 drückt dann die Federkontaktstifte um einen vorbestimmten Federweg, bspw. um 4 mm zusammen, indem sie die Kontaktspitzen 123 der Federkontaktstifte 111 und damit deren Kontaktglieder 118 mit den Zylindermänteln 117 gegen die Wirkung der zylindrischen Schraubenfedern 120 in Richtung auf den Anschlußkontaktträger 112 zubewegt, wobei auch die Ringschultern 122 der Kontaktglieder 118 auf der Oberseite der vorderen Führungsplatine 132 zu Anlage kommen, falls sie nicht bereits in der Ruhelage hier anlagen, und hierdurch nehmen die Kontaktköpfe 121 der Kontaktglieder 119 die vordere Führungsplatine 132 in der Bewegungsrichtung (Pfeil B) entsprechend mit. Der Federweg, um den dabei die einzelne Feder 120 zusammengedrückt wird, ist dabei so vorgesehen, daß am Ende des Federwegs die Kontaktspitze 123 mit vorbestimmter Kraft an die Leiterplatte 116 angedrückt ist, bspw. mit 100 bis 300 cN. Nunmehr kann der Auswerter, d. h. das Auswertegerät, an das dieser Prüfadapter 110 elektrisch angeschlossen ist, die elektrische Prüfung der Leiterplatte 116 auf Fehlerfreiheit durchführen, wobei diese Federkontaktstifte 111 Teile der elektrischen Verbindungen zwischen dem Auswertegerät und der jeweiligen Leiterplatte 116 bilden. Dieser erwähnte Federweg kann so groß sein, daß dabei das rückwärtige Ende des Zylindermantels 117 in die Bohrung 130 der Führungsplatine 131 eintaucht oder bis zu ihr oder bis nahe zu ihr gelangt. Nach erfolgter Prüfung wird die Leiterplatte 116 vom Prüfadapter 110 wieder entfernt und die Federkontaktstifte 111 und die vordere Führungsplatine 132 kehren in ihre Ruhestellungen zurück. Danach können weitere Leiterplatten 116 entsprechend geprüft werden. Die Bohrung 13o kann vorzugsweise gerinfügig grösseren Durchmesser als der Zylindermantel 117 aufweisen, so dass er in sie ggfs. eintauchen kann.

Es ist in manchen Fällen auch möglich, die vordere Führungsplatine 132 am Prüfadapter 110 unbeweglich so anzuordnen, daß der Kontaktkopf 121 des Federkontaktstiftes 111 zumindest in dem für den Federweg dieses Federkontaktstiftes 111 erforderlichen Ausmaß über die vordere Führungsplatine 132 übersteht, so daß der Ringbund 122 bei den Prüfungen von Leiterplatten 116 nicht bis zur Anlage an die Führungsplatine 132 gelangt. Der Zylindermantel 117 führt dann dem genannten Federweg entsprechend große Gleitbewegungen in der zugeordneten Bohrung 139 der Platine 132 aus.

Der an den Anschlußkontakt 113 angeschlossene,zum Auswertegerät weiterführende elektrische Leiter ist mit 114 bezeichnet.

## Ansprüche

1. Prüfadapter zum Kontaktieren von Leiterplatten zwecks deren Prüfung, welcher eine Vielzahl von metallischen Federkontaktstiften aufweist, die jeweils einen dünnen, rohrförmigen Zylindermantel aufweisen, dessen Länge vielfach größer als sein maximaler Außendurchmesser ist und der zusammen mit einem in seinem vorderen Endbereich koaxial zu ihm fest eingesetzten Kontaktglied einen Zylinder bildet, in dem ein Kolben eines zu ihm koaxialen Kolbengliedes axial gleitbar gelagert ist, wobei das Kontaktglied außerhalb des Zylindermantels einen dem Inkontaktkommen mit den Leiterplatten dienenden Kontaktkopf aufweist und der Kolben des Kolbenglieds über den Zylindermantel nach rückwärts übersteht und das Kolbenglied eine Bohrung einer rückwärtigen Führungsplatine des Prüfadapters durchdringt und einen Anschlußkontakt eines Kontaktträgers zum elektrischen Anschluß des Federkontaktstiftes kontaktiert, wobei ferner auf dem über den Zylindermantel überstehenden Bereich des Kolbenliedes eine Schraubendruckfeder angeordnet ist, die sich am rückwärtigen Stirnende des Zylindermantels und an einer Schulter des Kolbengliedes abstützt, wobei der Prüfadapter ferner eine vordere Führungsplatine aufweist, die für jeden Federkontaktstift eine Durchgangsbohrung aufweist, in der ein vorderer Längsbereich des Zylindermantels mit Gleitlagerspiel geführt ist, **dadurch gekennzeichnet,** daß das Kolbenglied(119) kürzer als die halbe Gesamtlänge des unbelasteten Federkontaktstiftes (111) ist und daß die Schraubendruckfeder (120) sich zumindest teilweise innerhalb der Bohrung (130) der rückwärtigen Führungsplatine (131) befindet.

2. Prüfadapter nach Anspruch 1, dadurch gekennzeichnet, daß das Verhältnis der Länge des unbelasteten Federkontaktstiftes (111) zur Länge des Kolbengliedes (119) größer als 2 : 1, vorzugsweise größer als 2,5 : 1 ist.

3. Prüfadapter nach Anspruch 2, dadurch gekennzeichnet, daß das genannte Verhältnis ungefähr 3 : 1 bis 4 : 1 beträgt.

4. Prüfadapter nach einem der vorhergehenden Ansprüche, dadurch gekennzeichnet, dass die Schraubendruckfeder (12o) sich auf einem Bereich des Kolbengliedes (119) befindet, der den Durchmesser des im Zylinder geführten Kolbenbereichs (126, 12″) aufweist und vorzugsweise einen Abstand von max. 5 mm vom benachbarten Ende des Kolbengliedes hat.

5. Prüfadapter nach einem der vorhergehenden Ansprüche,dadurch gekennzeichnet, dass das Kolbenglied im wesentlichen aus gehärtetem Stahl besteht.

FIG.1

FIG.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| P,A | DE-A-3 500 226 (RIBA PRÜFTECHNIK GmbH) <br> * Seite 6, Zeile 17 - Seite 7, Zeile 1; Seite 8, Zeile 34 - Seite 9, Zeile 1; Figur * <br><br> --- | 1,5 | G 01 R 1/067 <br> G 01 R 1/073 <br> H 01 R 11/18 |
| A | US-A-4 321 532 (L.J. LUNA) <br> * Spalte 4, Zeilen 28-68; Figuren 4,5 * <br><br> --- | 1 | |
| A | DE-U-8 417 746 (FEINMETALL GmbH) <br> * Seite 10, Zeilen 3-32; Seite 11, Zeilen 20-33; Figur 1 * <br><br> --- | 1 | |
| A | DE-A-3 103 077 (FEINMETALL GmbH) <br> * Seite 6, Zeilen 1-10; Anspruch 7; Figur * <br><br> ----- | 1,5 | **RECHERCHIERTE SACHGEBIETE (Int. Cl.4)** <br><br> G 01 R <br> H 01 R <br> H 05 K |

Der vorliegende Recherchenbericht wurde für alle Patentansprüche erstellt.

| Recherchenort | Abschlußdatum der Recherche | Prüfer |
|---|---|---|
| DEN HAAG | 10-07-1987 | PENZKOFER,B. |